# EUROPÄISCHE PATENTSCHRIFT

(11) **EP 0 201 728 B1**
(45) Veröffentlichungstag und Bekanntmachung des Hinweises auf die Patenterteilung: **07.07.1993**
(21) Anmeldenummer: 86104904.7
(22) Anmeldetag: 10.04.1986
(51) Int. Cl.: H03F 1/52

(54) **Leistungsverstärker mit mehreren Endstufen**
Power amplifier with multiple end stages
Amplificateur de puissance à plusieurs étages de sortie

(30) Priorität: 14.05.1985 DE 3517342
(43) Veröffentlichungstag der Anmeldung: 20.11.1986
(73) Patentinhaber: GRUNDIG E.M.V. Elektro-Mechanische Versuchsanstalt Max Grundig holländ. Stiftung & Co. KG., D-90762 Fürth (DE)
(72) Erfinder: Baumgartner, Franz Xaver, D-8501 Siegelsdorf (DE); Anding, Herbert, D-8500 Nürnberg (DE)

(56) Entgegenhaltungen:
- DE-A- 2 710 762
- FR-A- 2 498 844
- US-A- 4 053 996

## Beschreibung

Die Erfindung betrifft einen Leistungsverstärker der im Oberbegriff des Patentanspruchs angegebenen Art.

In der Zeitschrift Funkschau 24/1984, Seite 101, wird unter der Überschrift "1000-W-Kraftpaket" ein Leistungsverstärker beschrieben, in dessen Gehäuse zur Erhöhung der Luftströmung und damit zur Kühlung wärmeempfindlicher Bauelemente ein Lüftergebläse eingebaut ist. Das Lüftergebläse wird über einen Regelkreis betrieben, der die Drehzahl kontinuierlich in Abhängigkeit von der Bauelemente-Temperatur steuert.

Ferner ist aus der Patentanmeldung P 35 03 943.4 eine Steuereinrichtung für ein in einem Leistungsverstärker angeordnetes Lüftergebläse bekannt, mit der eine temperatur- und aussteuerungsabhängige Drehzahlregelung möglich ist.

Das Dokument "Linear Integrated Circuits" 2^{nd} Edition; Issued February 1981 S9S-ATES veröffentlicht einen Leistungsverstärker in Kompaktbauweise mit einer Endstufe, der eine die Temperatur der Bauelemente überwachende Schwellwertschaltung umfaßt, die beim Überschreiten einer vorgegebenen, unterhalb der zulässigen Höchsttemperatur liegenden Grenztemperatur die Endstufe abschaltet.

Der Nachteil der bekannten zusätzlichen Kühleinrichtungen, die insbesondere bei sehr kompakt aufgebauten Leistungsverstärkern hoher Ausgangsleistung, wie zum Beispiel Autoradioverstärkern, erforderlich sind, liegt vor allem in dem hohen kostenmäßigen und technischen Aufwand für das Lüftergebläse und den Regelkreis.

Der Erfindung liegt die Aufgabe zugrunde, einen Leistungsverstärker der im Oberbegriff des Patentanspruchs angegebenen Art so auszubilden, daß Übertemperaturen, die zu einer Zerstörung der Endstufen führen, mit einfachen Mitteln sicher vermieden werden.

Diese Aufgabe wird gemäß der Erfindung durch die im kennzeichnenden Teil des Patentanspruchs angegebenen Merkmale gelöst.

Der Leistungsverstärker gemäß der Erfindung verfügt über eine die Temperatur der Bauelemente überwachende Schwellwertschaltung, die in vorteilhafter Weise beim Überschreiten einer vorgegebenen, unterhalb der zulässigen Höchsttemperatur liegenden Grenztemperatur einen Teil der Endstufen abschaltet. Demzufolge braucht nur noch die als Wärme auftretende Verlustleistung der noch eingeschalteten Endstufen über das allen Endstufen gemeinsame Kühlelement abgeführt werden. Somit ist es möglich, auch ohne den Einsatz von zusätzlichen Kühleinrichtungen einen Verstärker zu realisieren, der trotz kompakter Bauweise über eine sehr hohe maximale Ausgangsleistung verfügt. Die Abschaltung eines Teils der Endstufen stellt damit in erster Linie eine Sicherheitsmaßnahme dar, die ausschließlich bei sehr extremer Aussteuerung und gegebenenfalls sehr hohen Umgebungstemperaturen wirksam wird.

Leistungsverstärker mit einer Steuereinrichtung gemäß der Erfindung eignen sich besonders für den Einsatz in Kraftfahrzeugen. Dort bietet es sich an, bei zu starker Erwärmung des Leistungsverstärkers die Endstufen für die Ansteuerung der im Heck befindlichen Lautsprecher abzuschalten. Hierdurch geht zwar der räumliche Klangeindruck vorübergehend verloren. Jedoch bleibt die Verständlichkeit des Rundfunkprogramms, insbesondere der Verkehrsdurchsagen, voll erhalten, da die Endstufen zur Ansteuerung der Frontlautsprecher mit ihrer vollen Leistung weiter betrieben werden können. Im übrigen hat der Leistungsverstärker gemäß der Erfindung gegenüber einem Verstärker mit Lüftergebläse den Vorteil, daß keine Nebengeräusche erzeugt werden, die das vom Gehör empfundene Signal-/GeräuschverhältniS verschlechtern.

Die Steuereinrichtung gemäß der Erfindung stellt somit eine preiswerte, technisch sehr einfache und dennoch sehr vorteilhafte und wirkungsvolle Lösung zur Vermeidung von schädlichen Übertemperaturen bei einem Leistungsverstärker mit mehreren gemeinsam gekühlten Endstufen in Kompaktbauweise dar.

## Patentansprüche

1. Leistungsverstärker in Kompaktbauweise mit mehreren Endstufen zur Front- und Heckbeschallung eines Kraftfahrzeuges, deren wärmeempfindliche Bauelemente auf einem gemeinsamen Kühlelement montiert sind,
**dadurch gekennzeichnet,** daß
eine die Temperatur der Bauelemente überwachende Schwellwertschaltung vorgesehen ist, die beim Überschreiten einer vorgegebenen, unterhalb der zulässigen Höchsttemperatur liegenden Grenztemperatur die für die Heckbschallung zuständigen Endstufen abschaltet.

## Claims

1. Power amplifier in a compact type of construction, having several output stages for supplying sound to the front and rear of a motor vehicle, the heat-sensitive components of which are mounted on a common heat sink, characterised in that a threshold circuit monitoring the temperature of the components is provided which, when a predetermined limit temperature below the permissible maximum temperature is exceeded, switches off the output stages responsible for supplying sound to the rear.

## Revendications

1. Amplificateur de puissance de type compact comportant plusieurs étages finals pour la sonorisation avant et arrière d'un véhicule automobile et dont les composants sensibles à la chaleur sont montés sur un élément de refroidissement commun,
caractérisé en ce qu'il est prévu un circuit à valeur de seuil, qui contrôle la température des composants et qui, en cas de dépassement d'une température limite prédéterminée inférieure à la température maximale admissible, débranche les étages finals affectés à la sonorisation arrière.
